# EUROPÄISCHE PATENTSCHRIFT

(11) **EP 2 707 904 B1**
(45) Veröffentlichungstag und Bekanntmachung des Hinweises auf die Patenterteilung: **14.09.2016**
(21) Anmeldenummer: 12753384.2
(22) Anmeldetag: 08.05.2012
(51) Int. Cl.: H01L 31/0203, H01L 31/024, H01L 23/373

(54) **OPTISCHE AUFNAHMEEINRICHTUNG**
OPTICAL RECORDING DEVICE
DISPOSITIF DE PRISE DE VUE OPTIQUE

(30) Priorität: 10.05.2011 DE 102011050246
(43) Veröffentlichungstag der Anmeldung: 19.03.2014
(73) Patentinhaber: Jena-Optronik GmbH, 07745 Jena (DE)
(72) Erfinder: MAGERL, Marion, 07747 Jena (DE); SCHMIDT, Uwe, 07616 Bürgel (DE)
(74) Vertreter: Ege & Lee Patentanwälte
(86) Internationale Anmeldenummer: PCT/DE2012/100132
(87) Internationale Veröffentlichungsnummer: WO 2012/152272

(56) Entgegenhaltungen:
- EP-A2- 0 899 795
- WO-A1-97/21080
- US-A- 4 862 002
- US-A1- 2004 165 356

## Beschreibung

Die Erfindung betrifft eine optische Aufnahmeeinrichtung in einem Raumflugkörper mit einem aktiv mittels eines Kühlelements gekühlten Detektor, einer auf diesen fokussierenden Optik, einer elektronischen Auswerteeinrichtung und einem Gehäuse mit einer die Optik und den Detektor aufnehmenden Grundplatte.

Gattungsbildende optische Aufnahmeeinrichtungen werden beispielsweise als Sternsensoren zur Navigation und zur Beobachtung des Weltraums, der Planeten und deren Trabanten wie beispielsweise der Erde und des Mondes, der Sonne in Form von Kameras, Spektrometern, Radiometern und dergleichen eingesetzt. Diese sind hierbei an Raumflugkörpern, beispielsweise Satelliten, Weltraumstationen, Raumfähren und dergleichen angebracht. Die besagten optischen Aufnahmeeinrichtungen enthalten dabei einen Detektor, beispielsweise einen CCD-Chip, CMOS Active Pixel Sensor, eine Photodiode oder dergleichen, auf denen mittels einer entsprechend abgestimmten Optik, beispielsweise einem Objektiv mit einem mehrere Linsen enthaltenden Tubus oder dergleichen der gewünschte Abbildungseffekt erzielt wird. Um einen hohen Dunkelstrom des Detektors, der sich in Bildrauschen, einem Helligkeitsoffset und dergleichen äußert, zu vermeiden, wird der Detektor durch ein Kühlelement, beispielsweise eine Peltierelement und dergleichen gekühlt.

Aus der DE 196 16 151 A1 sind Detektoren bekannt, die mittels Abstandshaltern auf einem Peltierelement vorgespannt sind, wobei das Peltierelement auf einer Grundplatte aufgenommen ist. Hierdurch wird eine über das Peltierelement führende Verbindungsstrecke aufgebaut, die zugleich die mechanische Steifigkeit gegenüber der Grundplatte und damit die Positionierung gegenüber der am Gehäuse befestigten Optik und die thermische Leitfähigkeit von dem Detektor über die kalte und warme Seite des Peltierelements auf die Grundplatte übernimmt. Hierbei kann ein "Pumpeffekt" durch einen temperaturabhängigen Ausdehnungsmodul des Kühlelements auftreten, der an der Fokussierebene des Detektors zu Ungenauigkeiten und Alignment-Fehlern führen kann.

Aufgabe der Erfindung ist daher, eine optische Aufnahmeeinrichtung vorzuschlagen, deren Detektor effektiv gekühlt und dennoch exakt positioniert gegenüber der Optik an der Grundplatte aufgenommen werden kann.

Die Aufgabe wird durch den Gegenstand des Anspruchs 1 gelöst. Die von dem Anspruch 1 abhängigen Ansprüche gegeben vorteilhafte Ausführungsformen des Gegenstands des Anspruchs 1 wieder. Die erste Verbindungsstrecke und die zweite Verbindungsstrecke lösen dabei die unterschiedlichen Teilaufgaben einer thermisch isolierten, steifen Aufnahme des Detektors einerseits und einer elastischen Abstützung des Kühlelements an der Grundplatte mit hoher thermischer Leitfähigkeit andererseits. Hierdurch bleibt die Fokussierebene wie lichtsensitive Fläche des Detektors exakt gegenüber der Optik wie Objektiv positioniert und die Wärme wird mit einem hohen Wärmefluss über das Kühlelement wie Peltierelement oder Wärmetauscher ähnlicher Ausprägung in die Grundplatte abgeleitet, wobei das Kühlelement und dessen Spannungsversorgung elastisch und damit unempfindlich gegen mechanische Einwirkungen auf den Detektor an der Grundplatte abgestützt ist.

Der Detektor kann bevorzugt ein Matrixdetektor sein, der über punkt, zeilen- oder rasterförmig auf einer Aufnahmefläche verteilte lichtsensitive Kanäle (Pixel) verfügt, deren Lichtsignale beispielsweise zyklisch mit einer vorgegebenen Taktrate von beispielsweise 10 Hertz in einer entsprechenden Auswerteeinrichtung wie Elektronik ausgewertet wie verarbeitet und gespeichert werden, um entsprechende Bildinformationen zu erhalten, die beispielsweise zur Navigation des Raumflugkörpers anhand von Sterndaten, der Weltraum- und/oder Erdbeobachtung und dergleichen dienen können. Hierbei hat sich als besonders vorteilhaft erwiesen, wenn als Detektoren CCDs oder sogenannte aktive Pixel-Sensoren (Active Pixel Sensor, APS) bevorzugt in Form von komplementären Metalloxid-Halbleitern (Complementary Metall Oxide Semiconductors; CMOS) verwendet werden, die gegenüber der Grundplatte und der Optik thermisch isoliert und aktiv beispielsweise mittels eines Peltierelements gekühlt sind. Dabei kann der Detektor auf einer elektronischen Schaltung lagestabilisiert aufgenommen sein, die in drahtloser oder verdrahteter Signalverbindung mit der Auswertelektronik der optischen Aufnahmeeinrichtung steht.

Die Optik ist den Ansprüchen an die optische Aufgabe der optischen Aufnahmeeinrichtung entsprechend ausgeführt und beispielsweise als auf unendliche Entfernung abgestimmtes Objektiv mit mehreren Linsen und/oder Linsengruppen ausgebildet, die in üblicher Weise in dem Objektivtubus, beispielsweise einen trichterförmigen aus Feinguss, spanend oder in anderer Weise beispielsweise aus Titan oder Aluminium hergestellten Objektivkörper verbaut sind.

Die Grundplatte nimmt zwei Baueinheiten auf, die beispielsweise aus dem Gehäuse, dem Streulichttubus und der Auswerteeinrichtung einerseits und dem Detektor und der Optik andererseits gebildet werden. Diese Baueinheiten sind hierbei ausschließlich mittels der Grundplatte gegeneinander positioniert und aufeinander zentriert. Dabei weist die eine Baueinheit einen mit der Grundplatte verbundenen und den Streulichttubus aufnehmenden Gehäuserahmen auf, an dem um die erste Baueinheit angeordnet Elektronikmodule der Auswerteeinrichtung aufgenommen sind. Der Gehäuserahmen kann aus mehreren, beispielsweise an Eckpunkten mit der Grundplatte verbundenen wie eingeschraubten Pfosten gebildet sein, an denen eine Aufnahmeplatte für den Streulichttubus befestigt wird. Weiterhin sind zwischen diesen Pfosten die Elektronikmodule der Auswerteeinrichtung befestigt. Diese können in Verbindung mit entsprechenden Abdichtelementen für Strahlung und Staubpartikel ein dichtes Gehäuse bilden. Die Elektronikmodule sind miteinander verbunden und können jeweils einzelne Module für die Datenverarbeitung, die Kommunikation mit dem Raumflugkörper mittels entsprechender Schnittstellen, Datenspeichereinrichtungen aufweisen. Zur Verbindung der einzelnen Elektronikmodule miteinander werden bevorzugt starrflexibel miteinander verbundene Leiterplatten (Starrflex-Leiterplatten) eingesetzt, die ohne Stecker auskommen und daher in dem wartungsfeindlichen Raumflugkörper besonders zuverlässige Verbindungen ausbilden.

Zwischen den Baueinheiten kann in der Grundplatte oder einem Adapter (Zwischenbauteil) eine thermische Isolierung vorgesehen sein, die durch eine vermindernde thermische Leitfähigkeit des gewählten Materials erzielt wird. Hierbei können entsprechend leichte und thermisch schlecht leitende und dennoch ausreichend stabile Materialien Verwendung finden, beispielsweise Titan und dessen Legierungen. Besonders vorteilhaft können an wenig mechanisch beanspruchten Bereichen und insbesondere zwischen den Aufnahmen der ersten und zweiten Baueinheit Materialschwächungen wie Ausnehmungen und/oder Durchbrüche vorgesehen werden, so dass neben einer thermischen Isolation gleichzeitig Gewicht eingespart werden kann.

Gemäß dem erfinderischen Gedanken ist der Detektor mittels der Verbindungsstrecke mechanisch steif und thermisch isoliert ausgebildet, während die zweite Verbindungsstrecke weniger steif, das heißt mechanisch elastischer ausgebildet ist. Hierbei kann die zweite mechanische Steifigkeit zwischen Detektor und Kühlelement größer als die dritte mechanische Steifigkeit ausgebildet sein, was bedeutet, dass das Kühlelement mechanisch an den Detektor gekoppelt und elastisch gegen die Grundplatte abgestützt ist. In einem bevorzugten alternativen Ausführungsbeispiel ist die zweite mechanische Steifigkeit kleiner als die dritte mechanische Steifigkeit ausgebildet, was bedeutet, dass das Kühlelement mechanisch der Grundplatte zugeordnet ist und elastisch mit dem Detektor verbunden ist. Es versteht sich, dass beide Steifigkeiten annähernd gleich groß sein können, das Kühlelement quasi schwimmend zwischen Detektor und Grundplatte angeordnet sein kann.

Die Einstellung einer der zweiten und dritten thermischen Leitfähigkeiten und zumindest einer der zweiten und dritten mechanischen Steifigkeiten erfolgt in vorteilhafter Weise mittels zumindest eines elastischen Wärmeleitelementes, welches in vorteilhafter Weise aus Silber besteht. Hierbei können eine kalte Seite des Kühlelements fest und wärmeleitend beispielsweise mittels einer Platine, eines anderen Zwischenstücks oder direkt dem Detektor und eine warme Seite des Kühlelements mittels des Wärmeleitelementes elastisch der Grundplatte zugeordnet sein. Unter einer derartigen Zuordnung ist die Mittelbare oder unmittelbare Befestigung wie Verklebung, Verschraubung, Verrastung und dergleichen des Kühlelements mit dem Detektor beziehungsweise der Grundplatte zu verstehen. Bevorzugt ist jedoch, eine warme Seite des Kühlelements fest und wärmeleitend mit der Grundplatte und eine kalte Seite des Kühlelements mittels einer Wärmeleitelementes elastisch mit einer Platine des Detektors zu verbinden.

Die gemäß dem erfinderischen Gedanken thermisch isolierend und mechanisch steif ausgebildete Verbindungsstrecke kann als Kegelhülse ausgebildet sein, an deren kleinem Durchmesser der Detektor aufgenommen und deren größerer Durchmesser mit der Grundplatte verbunden ist. Durch die kegelförmige Ausgestaltung kann bei guter Steifigkeit dünnes Material verwendet werden, das eine entsprechend verminderte thermische Leitfähigkeit aufweist. Es hat sich als vorteilhaft gezeigt, wenn in der Kegelhülse Ausnehmungen wie Bohrungen, Ausschnitte, Ausstanzungen und dergleichen vorgesehen sind, die deren Gewichtung und thermische Leitfähigkeit verringern ohne deren mechanische Steifigkeit in störendem Maße zu beeinträchtigen. Das Material der Kegelhülse kann den Anforderungen entsprechend gewählt werden. Als vorteilhaft haben sich Leichtmetalle erwiesen, wobei sich Titan infolge seiner geringen spezifischen Wärmeleitfähigkeit als besonders vorteilhaft erwiesen hat. Es versteht sich, dass wegen dieses Vorteils auch andere, nicht kegelhülsenförmig ausgebildete Verbindungsstrecken vorteilhaft ausgebildet werden können. Der Detektor kann dabei in vorteilhafter Weise mittels über den Umfang angeordneter, gegenüber einer Aufnahmefläche der Kegelhülse erhabener Aufnahmenocken exakt an der Kegelhülse positioniert sein, wobei die zwischen Aufnahmenocken und Aufnahmefläche verbleibenden Spalte mit Klebstoff gefüllt und dadurch der Detektor mit der Kegelhülse wirksam verbunden wird.

Die Optik ist den Ansprüchen an die optische Aufgabe der optischen Aufnahmeeinrichtung entsprechend ausgeführt und beispielsweise als auf unendliche Entfernung abgestimmtes Objektiv mit mehreren Linsen und/oder Linsengruppen ausgebildet, die in üblicher Weise in dem Objektivtubus, beispielsweise einen trichterförmigen aus Feinguss, spanend oder in anderer Weise beispielsweise aus Titan oder Aluminium hergestellten Objektivkörper verbaut sind.

Die Erfindung wird anhand der in den Figuren 1 bis 4 dargestellten Ausführungsbeispiele näher erläutert. Dabei zeigen:
- Figur 1: einen Schnitt durch eine als Sternsensor ausgebildete optische Aufnahmeeinrichtung in schematischer Darstellung,
- Figur 2: eine Ausführungsform einer Sensoreinrichtung mit aktiv gekühltem Detektor in Form eines Blockschaltbilds,
- Figur 3: eine 3D-Ansicht des Wärmeleitelements der Figur 1
und
- Figur 4: eine 3D-Ansicht der in der Figur 1 verwendeten Grundplatte.

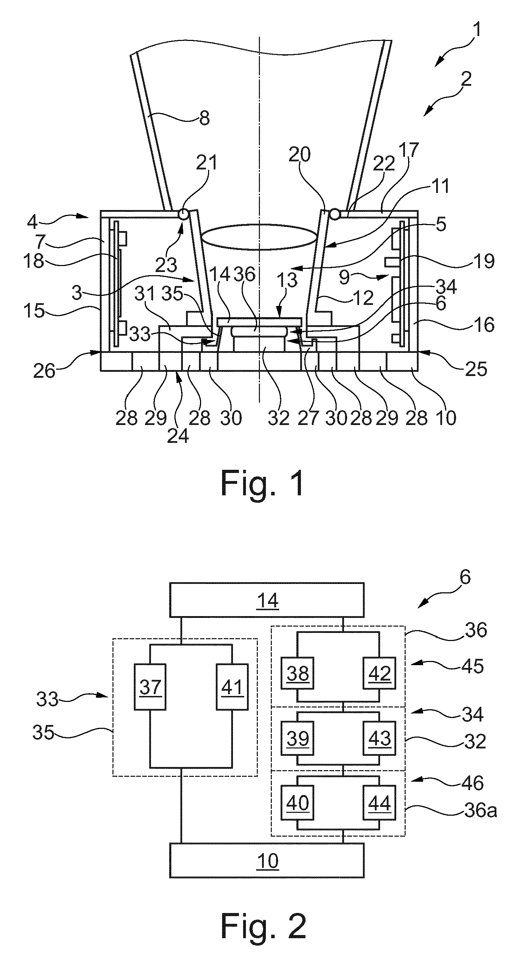

Figur 1 zeigt einen Schnitt durch die optische Aufnahmeeinrichtung 1 in Form des Sternsensors 2 mit den beiden Baueinheiten 3, 4. Die Baueinheit 3 beinhaltet die Optik 5 und die Sensoreinheit 6, die Baueinheit 4, das Gehäuse 7, den Streulichttubus 8 und die Auswerteeinrichtung 9. Die beiden Baueinheiten 3, 4 sind auf der Grundplatte 10 fest aufgenommen und im Übrigen voneinander mechanisch entkoppelt.

Die Optik 5 ist in dem gezeigten Ausführungsbeispiel aus dem Objektiv 11 mit dem Objektivtubus 12 und darin fest in einer vorgegebenen Position aufgenommenen Linsen zur Bildung einer Festbrennweite gebildet. Der Objektivtubus 12 ist mittels des Objektivhalters 31 mit der Grundplatte 10 verbunden wie verschraubt. Hierzu ist ein Flansch des Objektivs 11 mit dem Objektivhalter 31 verbunden wie verschraubt.

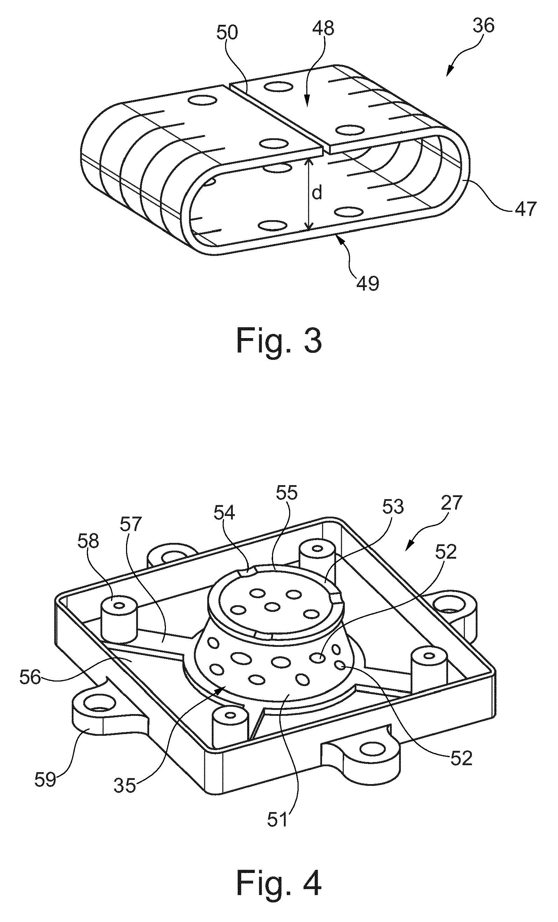

Die Sensoreinheit 6 mit dem Detektor 14 und dem Kühlelement 32 ist mittels der beiden Verbindungsstrecken 33, 34 mit der Grundplatte 10 verbunden. Hierbei ist die aus dem bevorzugt aus Titan hergestellten Adapter 27 mit der hier einteilig ausgebildeten Kegelhülse 35 gebildete erste Verbindungstrecke 33 zwischen dem Detektor 14, der direkt, mittels einer Leiterplatte oder einem mechanisch festen Bauteil an der Kegelhülse 35 fixiert ist, und der Grundplatte 10 mechanisch steifer und mit geringerer thermischer Leitfähigkeit verbunden als die Verbindungsstrecke 34, die einen guten Wärmeausgleich zwischen dem Detektor 14 und der kalten Seite des Kühlelements 32 einerseits und dessen warmer Seite und der Grundplatte 10, die selbst wieder ein guter Wärmeleiter ist und die Wärme lateral abführt, anderseits bildet. Der Adapter 27 ist mittels nicht dargestellter Befestigungsösen (Siehe Figur 4) an der Grundplatte 10 befestigt. Die Befestigung des Adapters 27 erfolgt dabei an beispielsweise mittels freigestellter Stege 30 oder dergleichen vergleichsweise biegeweichen Befestigungspunkten, so dass trotz exakter Positionierung ein Ausgleich der unterschiedlichen Wärmeausdehnungskoeffizienten der Materialien der Grundplatte 10 und des Adapters 27 ausgeglichen werden kann. In einem alternativen, vorteilhaften Ausführungsbeispiel können der Adapter 27 und die Optik 5 mittels des Objektivtubus 12 direkt oder mittels dessen Objektivhalters 31 an denselben Befestigungspunkten der Grundplatte 10 befestigt sein, so dass Detektor 14 und Objektiv 11 in besonders vorteilhafter Weise aufeinander zentriert sind. Hierbei fallen die Stege 29, 30 zusammen.

Zugleich weist die Verbindungsstrecke 34 eine geringe mechanische Steifigkeit auf, damit sich beispielsweise über die Temperatur ändernde Abmaße des Kühlelements 32 ausgleichen lassen, ohne die Fokussierebene 13 des Detektors negativ zu beeinflussen. Die exakte Positionierung der Fokussierebene 13 gegenüber dem Objektiv 11 wird durch die mechanisch steife Aufnahme des Objektivs 11 über den Objektivhalter 31 und der mechanisch steifen Aufnahme des Detektors 14 mittels der ersten Verbindungsstrecke 33 sowie deren gemeinsame Befestigung an der steifen Grundplatte 10 erzielt. In dem gezeigten Ausführungsbeispiel erfolgt die Ableitung der in dem Detektor 14 erzeugten Wärme über den beispielsweise aus Wärmeleitstreifen aus bevorzugt elastisch miteinander verbundenen Silberpartikeln gebildeten Wärmeleitelemente 36 oder dergleichen, der eine elastische und damit mit geringer Steifigkeit und hoher thermischer Leitfähigkeit ausgebildete Verbindung zwischen dem Detektor 14 und der kalten Seite des Kühlelements 32 herstellt. Hierbei ist das Kühlelement 32 direkt an der gut thermisch leitenden, beispielsweise aus Aluminium hergestellten Grundplatte 10 gegebenenfalls unter Bildung einer thermisch leitenden Zwischenschicht aufgenommen, so dass der Detektor 14 nicht mit statischen und dynamischen Massekräften belastet wird. In alternativen Ausführungsbeispielen - beispielsweise insoweit die aufgeführten Massekräfte von untergeordneter Bedeutung sind - kann die Position des Kühlelements 32 und des Wärmeleitelements 36 vertauscht sein, so dass das Kühlelement direkt mit seiner kalten Seite an dem Detektor 14 ankoppelt.

Der Objektivhalter 31 isoliert die Baueinheit 3 und der Adapter 27 den Detektor 14 gegenüber der Grundplatte 10 und damit gegenüber der Baueinheit 4 sowohl bezüglich Massenkräften als auch gegenüber thermischen Einflüssen. Hierzu sind diese an den zwischen den Durchbrüchen 28 gebildeten Stegen 29, 30 aufgenommen wie verschraubt. Weiterhin kann der Objektivhalter 31 aus thermisch schlecht leitendem Material wie Titan ausgebildet sein. Zur exakten Positionierung des Objektivs 11 gegenüber der Sensoreinheit 6 und letztendlich über die Grundplatte 10 gegenüber der Baueinheit 4 sind entsprechende bevorzugt zwischen Objektivtubus 12 und dem Objektivhalter 31 Positionierungsmittel vorgesehen.

Die Sensoreinheit 6 enthält den direkt unterhalb der Fokussierebene 13 angeordnete Detektor 14 beispielsweise in Form eines CCD oder CMOS-Chips, das von einer Deckscheibe, die durchsichtig bevorzugt zum Schutz oder als Filter ausgebildet sein kann, abgedeckt wird und mit einer Vorortelektronik beispielsweise einer elektronischen Leiterplatte kontaktiert ist.

Das Gehäuse 7 der Baueinheit 4 ist aus den Gehäuseplatten 15, 16 und der Aufnahmeplatte 17, an der der Streulichttubus 8 angeordnet ist, gebildet. Der Streulichttubus 8 ist hierbei an der Aufnahmeplatte 17 zentriert aufgenommen und beispielsweise verschraubt. Die Gehäuseplatten 15, 16 sind an nicht einsehbaren Pfosten, die mit der Aufnahmeplatte 17 und der Grundplatte 10 fest verbunden wie verschraubt sind, befestigt. Grundplatte 10 und Gehäuseplatten 15, 16 können jeweils mittels einer Dichtung gegeneinander abgedichtet sein. An den Gehäuseplatten 15, 16 sind jeweils Leiterplatten 18, 19 teilweise mehrstöckig angeordnet und befestigt.

Im zum Streulichttubus 8 gewandten Endbereich des Objektivs 11 ist der im Wesentlichen konisch zulaufende Objektivring 20 angebracht, der mit dem eine zentrale Öffnung bildenden komplementären Ansatz 22 den Ringspalt 23 bildet, der unterschiedliche thermische Ausdehnungskoeffizienten der Materialien des Objektivs 11 und der Aufnahmeplatte 17 ausgleicht, ohne das Objektiv 11 gegen den Ansatz 22 zu verzwängen oder eine mechanische Überbestimmung herbeizuführen. Gleichzeitig wird der Ringspalt 23 so eng ausgebildet, dass größere Relativbewegungen, beispielsweise unter Beschleunigung während des aktiven oder passiven Starts des Raumflugkörpers verhindert werden und daher eine Beschädigung des Objektivs 11 und dessen Aufnahme vermieden wird. Zur elastischen Abstützung des Objektivs 11 ist in dem Ringspalt 23 der elastische, mit Metallanteilen versehene Dichtring 21 vorgesehen, der infolge seiner Metallanteile zusätzlich den Ringspalt gegen elektromagnetische Einstrahlungen verschließt.

Durch die Trennung der Baueinheiten 3, 4 wird der Streulichttubus 8 von der Baueinheit 3 abgekoppelt und von der Baueinheit 4 getragen. Hierbei ist die Optik 5 mechanisch und thermisch entlastet. Die unterschiedliche Befestigung des Streulichttubus 8 und der Optik 5 hat hierbei unter gegebenen Toleranzen einen geringeren störenden Einfluss als die mechanische Belastung der Optik 5 bei angebautem Streulichttubus 8 und ist unter mechanischer Belastung weniger störanfällig.

Zur Isolierung beziehungsweise Entkoppelung gegenüber Massenkräften zwischen den Baueinheiten 3, 4 ist die Grundplatte 10 mit der Profilstruktur 24 versehen, die gezielt und abhängig von der Positionierung der Aufnahmestellen 25, 26 der Baueinheiten 3, 4 gegeneinander Materialschwächungen 27 aufweisen kann.

Figur 2 zeigt die Sensoreinheit 6 der Figur 1 in Blockdarstellung zur detaillierten Erläuterung der mechanischen Steifigkeiten 37, 38, 39, 40 und thermischen Leitfähigkeiten 41, 42, 43, 44 zwischen dem Detektor 14 und der Grundplatte 10. Zur Entkoppelung des Wärmeflusses und der mechanischen Kraftübertragung sind die beiden parallel zueinander angeordneten Verbindungsstrecken 33, 34 vorgesehen, wobei die Verbindungsstrecke 34 durch das Kühlelement 32 in zwei weitere, seriell zueinander angeordnete Verbindungsstrecken 45, 46 unterteilt ist. Die Verbindungsstrecke 33 ist in dem gezeigten Ausführungsbeispiel durch die Kegelhülse 35 aus Titan gebildet.

Die mechanische Steifigkeit 37 der Verbindungsstrecke 33 ist gegenüber den hintereinander geschalteten mechanischen Steifigkeiten 38, 39, 40 der Verbindungsstrecke 34 groß, so dass die Führung und Positionierung des Detektors 14 auf der Grundplatte 10 praktisch ausschließlich über die Verbindungsstrecke 33 erfolgt. Demgegenüber ist die thermische Leitfähigkeit 41 klein gegenüber den thermischen Leitfähigkeiten 42, 43, 44 der Verbindungsstrecke 34, so dass der Wärmefluss im Wesentlichen über die Verbindungsstrecke 34 abgeleitet wird und über die Verbindungsstrecke 33 keine die Positionierung beispielsweise durch thermische Spannungen und Ausdehnungen bewirkte Wärmeflüsse an der Verbindungsstrecke 33 auftreten.

Die Verbindungsstrecke 34 enthält das Kühlelement 32 mit relativ hoher mechanischer Steifigkeit 39, wobei sich die Ausdehnung des Kühlelements 32 bei Temperaturänderungen außerdem ändert ("Pumpen"). Diese Änderungen werden je nach Anordnung des Kühlelements 32 an der Grundplatte 10 oder am Detektor 14 durch die geringe mechanische Steifigkeit 38 beziehungsweise 40 und damit hohe Elastizität der Wärmeileitpuffer 36, 36a kompensiert. Je nach Anordnung des Kühlelements 32 mit geringerem Abstand zur Grundplatte 10 beziehungsweise dem Detektor 14 können die Wärmeleitelemente 36, 36a im Falle einer dickeren Ausführung eine höhere mechanische Steifigkeit 38, 40 ausbilden als der Wärmeleitelement 36a, 36 mit größerem Abstand, um das Kühlelement 32 an dessen Aufnahme an der Grundplatte 10 beziehungsweise Detektor 14 oder einem mit diesem fest verbundenen Bauteil wie Platine oder dergleichen besser fixieren zu können.

Figur 3 zeigt eine 3D-Ansicht des Wärmeleitelements 36 der Figur 1. Das Wärmeleitelement 36 ist aus mehreren gebogenen Silberstreifen 47 wie Silberbänder gebildet, die - wie hier angedeutet - mehrlagig aufeinander angeordnet sind und einen mechanisch festen und zwischen den Auflageflächen 48, 49 justierbaren Abstand d bilden. Das Wärmeleitelement 36 wird mit seiner Auflagefläche 49 mit der kalten Seite des auf der Grundplatte 10 vormontierten Kühlelements 32 (Figur 1) verbunden wie verklebt. Nach der Justage des Abstands d wird der Detektor 14 unter leichter Druckvorspannung mit der Auflagefläche 49 verbunden, beispielsweise verklebt. Es versteht sich, dass die Auflageflächen 48, 49 vertauscht werden können, so dass der Schlitz 50 wahlweise am Detektor oder dem Kühlelement zugewandt ist. Durch Wärmeänderungen bedingte Ausdehnungen des Kühlelementes 32 (Figur 1) werden in dem gezeigten Wärmeleitelement durch die bogenförmige, elastische Beabstandung der Aufnahmeflächen 48, 49 ausgeglichen.

Figur 4 zeigt den an der Grundplatte 10 der Figur 1 aufgenommenen Adapter 27 in 3D-Ansicht. In dem gezeigten Ausführungsbeispiel ist die an dem Adapter 27 anschließende Kegelhülse 35 mit dem Adapter 27 einteilig ausgebildet. In alternativen Ausführungsbeispielen können Adapter 27 und Kegelhülse 35 getrennt voneinander ausgebildet und aufeinander befestigt sein, wobei der Adapter einerseits an der Grundplatte befestigt ist und andererseits die Kegelhülse aufnimmt. Der Adapter 27 und bzw. oder die Kegelhülse 35 sind bevorzugt aus Titan hergestellt und isolieren den Detektor 14 (Figur 1) thermisch gegen die Grundplatte. Zur Minimierung der thermischen Leitfähigkeit ist die Materialstärke der Kegelhülse 35 dünn, beispielsweise mit einer Wandstärke kleiner einem Millimeter ausgebildet. Zusätzlich weist der Kegelmantel 51 der Kegelhülse 35 zur Verringerung der thermischen Leitfähigkeit und Gewichtseinsparung Durchbrüche 52 auf, die hier über den Umfang verteilt und kreisförmig vorgesehen sind und abhängig von der auszulegenden Statik einen entsprechenden Anteil des Kegelmantels 51 einnehmen können.

Am freien Ende der Kegelhülse 35 ist die Aufnahmefläche 53 für den Detektor 14 der Figur 1 vorgesehen. Die Kegelhülse 35 kann hierzu radial erweitert sein, um die Aufnahmefläche 53 zu vergrößern. Bevorzugt ist der Detektor mit der Aufnahmefläche 53 inelastisch verklebt, verschraubt und/oder verrastet oder in ähnlicher Weise verbunden. Die Aufnahmefläche 53 ist gegenüber einer vergleichbaren Optik der Figur 1 justiert, so dass Abstands- und Alignment-Fehler der Optik gegenüber dem Detektor minimiert werden. In dem gezeigten Ausführungsbeispiel sind zur exakten Positionierung und Justierung drei über den Umfang der Aufnahmefläche 53 erhabene Nocken 54 vorgesehen, die den Detektor aufnehmen. Die Verklebung des Detektors erfolgt mittels zwischen den Freiräumen 55 zwischen den Nocken 54 und dem Detektor aufgetragenen Klebstoffs.

Der Boden 56 des Adapters 27 verfügt über von der Anwendung abhängige Strukturierungen wie Ausnehmungen, Durchbrüche und dergleichen auf, um einerseits eine mechanisch hohe Festigkeit bei geringer Wärmeübertragung, ein niedriges Gewicht und geringe Materialkosten zu erzielen. Beispielsweise sind in dem gezeigten Ausführungsbeispiel Verstärkungsrippen 57 zwischen der Kegelhülse 35 und Aufnahmepunkten 58 beispielsweise zur Aufnahme einer zentralen Elektronik zur Beschaltung des Detektors oder dergleichen vorgesehen. An den Befestigungsösen 59 wird der Adapter 27 an der Grundplatte 10 aufgenommen. Die an der Grundplatte 10 hierzu vorgesehenen Befestigungspunkte können dabei als freigestellte Stege 30 (Figur 1) ausgebildet sein, die die unterschiedlichen Wärmeausdehnungskoeffizienten der verwendeten Materialien - hier Aluminium und Titan - auszugleichen. Durch den hochsymmetrischen Aufbau des Adapters 27 einerseits und der Grundplatte 10 der Figur 1 andererseits können Wärmeausdehnungen des Adapters 27 durch entsprechende Belastung der Stege gleichmäßig ausgeglichen werden, so dass die Kegelhülse 35 und damit der auf ihr befestigte Detektor weitgehend zentriert und lagestabil angeordnet bleiben. Durch die kegelförmige Ausbildung der Kegelhülse 35 erfolgt die Lagerung des Detektors entlang der optischen Achse des Objektivs in besonders steifer Weise.

### Bezugszeichenliste

- 1: Optische Aufnahmeeinrichtung
- 2: Sternsensor
- 3: Baueinheit
- 4: Baueinheit
- 5: Optik
- 6: Sensoreinheit
- 7: Gehäuse
- 8: Streulichttubus
- 9: Auswerteeinrichtung
- 10: Grundplatte
- 11: Objektiv
- 12: Objektivtubus
- 13: Fokussierebene
- 14: Matrixdetektor
- 15: Gehäuseplatte
- 16: Gehäuseplatte
- 17: Aufnahmeplatte
- 18: Leiterplatte
- 19: Leiterplatte
- 20: Objektivring
- 21: Dichtring
- 22: Ansatz
- 23: Ringspalt
- 24: Profilstruktur
- 25: Aufnahmestelle
- 26: Aufnahmestelle
- 27: Adapter
- 28: Durchbruch
- 29: Steg
- 30: Steg
- 31: Objektivhalter
- 32: Kühlelement
- 33: Verbindungsstrecke
- 34: Verbindungsstrecke
- 35: Kegelhülse
- 36: Wärmeleitelement
- 36a: Wärmeleitelement
- 37: mechanische Steifigkeit
- 38: mechanische Steifigkeit
- 39: mechanische Steifigkeit
- 40: mechanische Steifigkeit
- 41: thermische Leitfähigkeit
- 42: thermische Leitfähigkeit
- 43: thermische Leitfähigkeit
- 44: thermische Leitfähigkeit
- 45: Verbindungsstrecke
- 46: Verbindungsstrecke
- 47: Silberstreifen
- 48: Auflagefläche
- 49: Auflagefläche
- 50: Schlitz
- 51: Kegelmantel
- 52: Durchbruch
- 53: Aufnahmefläche
- 54: Nocken
- 55: Freiraum
- 56: Boden
- 57: Verstärkungsrippe
- 58: Aufnahmepunkt
- 59: Befestigungsöse

## Patentansprüche

1. Optische Aufnahmeeinrichtung (1) für einen Raumflugkörper mit einem aktiv mittels eines Kühlelements (32) gekühlten Detektor (14), einer auf diesen fokussierenden Optik (5), einer elektronischen Auswerteeinrichtung (9) und einem Gehäuse (7) mit einer die Optik (5) und den Detektor (14) aufnehmenden Grundplatte (10), **dadurch gekennzeichnet, dass** der Detektor (14) mittels einer ersten Verbindungsstrecke (33) mit einer ersten thermischen Leitfähigkeit (41) und einer ersten, den Detektor (14) gegenüber der Grundplatte abstützenden mechanischen Steifigkeit (37) auf der Grundplatte (10) aufgenommen ist und mittels einer zweiten Verbindungsstrecke (34) mit einem zwischengeschalteten Kühlelement (32) mit dem Gehäuse (10) verbunden ist, wobei zwischen Detektor (14) und dem Kühlelement (32) eine zweite thermische Leitfähigkeit (42) und eine zweite, das Kühlelement (32) gegenüber der Grundplatte (10) abstützende mechanische Steifigkeit (38) sowie zwischen Kühlelement (32) und Grundplatte (10) eine dritte thermische Leitfähigkeit (44) und eine dritte mechanische Steifigkeit (40) wirksam vorgesehen sind und wobei die erste thermische Leitfähigkeit (41) kleiner als eine Summe der zweiten und dritten thermischen Leitfähigkeiten (42, 44) und die erste mechanische Steifigkeit (37) größer als zumindest eine der zweiten und dritten mechanischen Steifigkeiten (38,40) vorgesehen sind.

2. Optische Aufnahmeeinrichtung nach Anspruch 1, **dadurch gekennzeichnet, dass** die zweite mechanische Steifigkeit (38) größer als die dritte mechanische Steifigkeit (40) ist.

3. Optische Aufnahmeeinrichtung (1) nach Anspruch 1, **dadurch gekennzeichnet, dass** die zweite mechanische Steifigkeit (38) kleiner als die dritte mechanische Steifigkeit (40) ist.

4. Optische Aufnahmeeinrichtung (1) nach einem der Ansprüche 1 bis 3, **dadurch gekennzeichnet, dass** zumindest eine der zweiten und dritten thermischen Leitfähigkeiten (42, 44) und zumindest eine der zweiten und dritten mechanischen Steifigkeiten (38, 40) mittels zumindest eines über zumindest einen Teilbereich elastischen Wärmeleitelements (36, 36a) eingestellt ist.

5. Optische Aufnahmeeinrichtung (1) nach Anspruch 4, **dadurch gekennzeichnet, dass** das Wärmeleitelement (36) aus mehrlagigen Silberstreifen (47) gebildet ist.

6. Optische Aufnahmeeinrichtung (1) nach Anspruch 4 oder 5, **dadurch gekennzeichnet, dass** eine Druckspannung zwischen dem Kühlelement (32) und dem Detektor (14) mittels des Wärmeleitelements (36) justiert ist.

7. Optische Aufnahmeeinrichtung nach einem der Ansprüche 4 bis 6, **dadurch gekennzeichnet, dass** eine kalte Seite des Kühlelements (32) fest und wärmeleitend dem Detektor (14) und eine warme Seite des Kühlelements (32) mittels eines Wärmeleitelements (36a) elastisch der Grundplatte zugeordnet ist.

8. Optische Aufnahmeeinrichtung (1) nach einem der Ansprüche 4 bis 6, **dadurch gekennzeichnet, dass** eine warme Seite des Kühlelements (32) fest und wärmeleitend der Grundplatte (10) und eine kalte Seite des Kühlelements (32) mittels eines Wärmeleitelements (36) elastisch dem Detektor (14) zugeordnet ist.

9. Optische Aufnahmeeinrichtung (1) nach einem der Ansprüche 1 bis 8, **dadurch gekennzeichnet, dass** die erste Verbindungsstrecke (33) als Kegelhülse (35) ausgebildet ist, an deren kleinem Durchmesser der Detektor (14) aufgenommen und deren größerer Durchmesser mit der Grundplatte (10) verbunden ist.

10. Optische Aufnahmeeinrichtung (1) nach Anspruch 9, **dadurch gekennzeichnet, dass** in einem Kegelmantel (51) der Kegelhülse (35) Durchbrüche (52) vorgesehen sind.

11. Optische Aufnahmeeinrichtung (1) nach einem der Ansprüche 1 bis 10, **dadurch gekennzeichnet, dass** die erste Verbindungsstrecke (33) aus Titan gebildet ist.

12. Optische Aufnahmeeinrichtung (1) nach einem der Ansprüche 9 bis 11, **dadurch gekennzeichnet, dass** die Optik (5) und die Kegelhülse (35) an gemeinsamen Befestigungspunkten der Grundplatte (10) aufgenommen sind.

13. Optische Aufnahmeeinrichtung (1) nach Anspruch 12, **dadurch gekennzeichnet, dass** die Befestigungspunkte an freigestellten Stegen der Grundplatte angeordnet sind.

## Claims

1. Optical recording device (1) for a space craft, with a detector (14) which is actively cooled by means of a cooling element (32), a lens (5) focusing on said detector, an electronic evaluation device (9) and a housing (7) having a base plate (10) accommodating the lens (5) and the detector (14), **characterized in that** the detector (14) is accommodated on the base plate (10) by means of a first connecting section (33) having a first thermal conductivity (41) and a first mechanical rigidity (37) which supports the detector (14) in relation to the base plate, and is connected to the housing (10) by means of a second connecting section (34) with a cooling element (32) connected in between, wherein a second thermal conductivity (42) and a second mechanical rigidity (38) which supports the cooling element (32) in relation to the base plate (10) are effectively provided between detector (14) and the cooling element (32), and a third thermal conductivity (44) and a third mechanical rigidity (40) are effectively provided between cooling element (32) and base plate (10), and wherein the first thermal conductivity (41) is provided to be less than a sum of the second and third thermal conductivities (42, 44), and the first mechanical rigidity (37) is provided to be greater than at least one of the second and third mechanical rigidities (38, 40).

2. Optical recording device according to Claim 1, **characterized in that** the second mechanical rigidity (38) is greater than the third mechanical rigidity (40).

3. Optical recording device (1) according to Claim 1, **characterized in that** the second mechanical rigidity (38) is less than the third mechanical rigidity (40).

4. Optical recording device (1) according to one of Claims 1 to 3, **characterized in that** at least one of the second and third thermal conductivities (42, 44) and at least one of the second and third mechanical rigidities (38, 40) is set by means of at least one heat-conducting element (36, 36a) which is elastic over at least a partial region.

5. Optical recording device (1) according to Claim 4, **characterized in that** the heat-conducting element (36) is formed from a multi-layer silver strip (47).

6. Optical recording device (1) according to Claim 4 or 5, **characterized in that** a compressive stress between the cooling element (32) and the detector (14) is adjusted by means of the heat-conducting element (36).

7. Optical recording device according to one of Claims 4 to 6, **characterized in that** a cold side of the cooling element (32) is assigned in a fixed and heat-conducting manner to the detector (14), and a hot side of the cooling element (32) is assigned elastically to the base plate by means of a heat-conducting element (36a).

8. Optical recording device (1) according to one of Claims 4 to 6, **characterized in that** a hot side of the cooling element (32) is assigned in a fixed and heat-conducting manner to the base plate (10), and a cold side of the cooling element (32) is assigned elastically to the detector (14) by means of a heat-conducting element (36).

9. Optical recording device (1) according to one of Claims 1 to 8, **characterized in that** the first connecting section (33) is designed as a conical sleeve (35), on the small diameter of which the detector (14) is accommodated and the larger diameter of which is connected to the base plate (10).

10. Optical recording device (1) according to Claim 9, **characterized in that** apertures (52) are provided in a cone envelope (51) of the conical sleeve (35).

11. Optical recording device (1) according to one of Claims 1 to 10, **characterized in that** the first connecting section (33) is formed from titanium.

12. Optical recording device (1) according to one of Claims 9 to 11, **characterized in that** the lens (5) and the conical sleeve (35) are accommodated on common fastening points of the base plate (10).

13. Optical recording device (1) according to Claim 12, **characterized in that** the fastening points are arranged on freed webs of the base plate.

## Revendications

1. Dispositif de prise de vue optique (1) pour un engin spatial avec un détecteur (14) refroidi de manière active au moyen d'un élément de refroidissement (32), un système optique (5) se focalisant sur celui-ci, un dispositif d'évaluation électronique (9) et un boîtier (7) avec une plaque de base (10) recevant le système optique (5) et le détecteur (14), **caractérisé en ce que** le détecteur (14) est logé sur la plaque de base (10) au moyen d'une première ligne de liaison (33) avec une première conductibilité thermique (41) et une première rigidité mécanique (37) soutenant le détecteur (14) vis-à-vis de la plaque de base et est relié au boîtier (10) au moyen d'une deuxième ligne de liaison (34) à un élément de refroidissement (32) intercalé, une deuxième conductibilité thermique (42) et une deuxième rigidité mécanique (38) soutenant l'élément de refroidissement (32) vis-à-vis de la plaque de base (10) étant prévues actives entre le détecteur (14) et l'élément de refroidissement (32) ainsi qu'une troisième conductibilité thermique (44) et une troisième rigidité mécanique (40) étant prévues actives entre l'élément de refroidissement (32) et la plaque de base (10) et la première conductibilité thermique (41) étant prévue plus petite qu'une somme de la deuxième et de la troisième conductibilité thermique (42, 44) et la première rigidité mécanique (37) étant prévue plus grande qu'au moins une des deuxième et troisième rigidités mécaniques (38, 40).

2. Dispositif de prise de vue optique selon la revendication 1, **caractérisé en ce que** la deuxième rigidité mécanique (38) est plus grande que la troisième rigidité mécanique (40).

3. Dispositif de prise de vue optique (1) selon la revendication 1, **caractérisé en ce que** la deuxième rigidité mécanique (38) est plus petite que la troisième rigidité mécanique (40).

4. Dispositif de prise de vue optique (1) selon l'une quelconque des revendications 1 à 3, **caractérisé en ce qu'**au moins une des deuxième et troisième conductibilités thermiques (42, 44) et au moins une des deuxième et troisième rigidités mécaniques (38, 40) est réglée au moyen d'au moins un élément thermoconducteur élastique (36, 36a) sur au moins un secteur partiel.

5. Dispositif de prise de vue optique (1) selon la revendication 4, **caractérisé en ce que** l'élément thermoconducteur (36) est formé de lames d'argent multicouches (47).

6. Dispositif de prise de vue optique (1) selon la revendication 4 ou 5, **caractérisé en ce qu'**une contrainte de compression est ajustée entre l'élément de refroidissement (32) et le détecteur (14) au moyen de l'élément thermoconducteur (36).

7. Dispositif de prise de vue optique selon l'une quelconque des revendications 4 à 6, **caractérisé en ce qu'**un côté froid de l'élément de refroidissement (32) est attribué de manière solide et thermoconductrice au détecteur (14) et un côté chaud de l'élément de refroidissement (32) est attribué de manière élastique à la plaque de base au moyen d'un élément thermoconducteur (36a).

8. Dispositif de prise de vue optique (1) selon l'une quelconque des revendications 4 à 6, **caractérisé en ce qu'**un côté chaud de l'élément de refroidissement (32) est attribué de manière solide et thermoconductrice à la plaque de base (10) et un côté froid de l'élément de refroidissement (32) est attribué de manière élastique au détecteur (14) au moyen d'un élément thermoconducteur (36).

9. Dispositif de prise de vue optique (1) selon l'une quelconque des revendications 1 à 8, **caractérisé en ce que** la première ligne de liaison (33) est constituée comme un manchon conique (35) sur le petit diamètre duquel est logé le détecteur (14) et dont le diamètre plus grand est relié à la plaque de base (10).

10. Dispositif de prise de vue optique (1) selon la revendication 9, **caractérisé en ce que** des passages (52) sont prévus dans une gaine conique (51) du manchon conique (35).

11. Dispositif de prise de vue optique (1) selon l'une quelconque des revendications 1 à 10, **caractérisé en ce que** la première ligne de liaison (33) est formée de titane.

12. Dispositif de prise de vue optique (1) selon l'une quelconque des revendications 9 à 11, **caractérisé en ce que** le système optique (5) et le manchon conique (35) sont logés sur des points de fixation communs de la plaque de base (10).

13. Dispositif de prise de vue optique (1) selon la revendication 12, **caractérisé en ce que** les points de fixation sont disposés sur des moulures posées librement sur la plaque de base.
